Europäisches Patentamt

European Patent Office

Office européen des brevets

(19)

(11) Publication number: **0 040 453**

**B1**

(12) **EUROPEAN PATENT SPECIFICATION**

(45) Date of publication of patent specification: **15.04.87**

(51) Int. Cl.⁴: **G 01 R 27/16**

(21) Application number: **81200518.9**

(22) Date of filing: **14.05.81**

(54) R.F. impedance determination.

(30) Priority: **20.05.80 GB 8016575**
**13.04.81 GB 8111625**

(43) Date of publication of application:
**25.11.81 Bulletin 81/47**

(45) Publication of the grant of the patent:
**15.04.87 Bulletin 87/16**

(84) Designated Contracting States:
**DE FR GB IT**

(56) References cited:
**DE-B-1 251 428**
**DE-B-2 044 500**
**GB-A- 881 018**
**GB-A-1 146 859**
**GB-A-1 444 328**
**GB-A-1 565 166**
**GB-A-2 002 613**
**US-A-2 745 067**
**US-A-3 919 644**

(73) Proprietor: **PHILIPS ELECTRONIC AND
ASSOCIATED INDUSTRIES LIMITED
Arundel Great Court 8 Arundel Street
London WC2R 3DT (GB)**
(84) **GB**

(73) Proprietor: **N.V. Philips' Gloeilampenfabrieken
Groenewoudseweg 1
NL-5621 BA Eindhoven (NL)**
(84) **DE FR IT**

(72) Inventor: **Underhill, Michael James
c/o PHILIPS RESEARCH LABORATORIES Redhill
Surrey, RH1 5HA (GB)**

(74) Representative: **Boxall, Robin John et al
Philips Electronic and Associated Ind. Ltd.
Patent Department Mullard House Torrington
Place
London WC1E 7HD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to a method of deriving information of the value of the R.F. impedance presented by an electrical network at a port thereof in relation to at least one desired locus in the complex impedance plane, utilising a reference signal supplied by a source of R.F. signals that is included in the network and using an arrangement which comprises network means auxiliary to the network of whose R.F. impedance it is desired to derive information and which further comprises indicating means responsive to R.F. signals, the method comprising:—

connecting said arrangement to said port successively in two different states, and using the indicating means to indicate whether there is any difference between the respective values in the two states of at least one of the two parameters, amplitude and phase respectively, of the signal supplied to the indicating means when the reference signal is supplied to said arrangement by the source.

characteristics of the auxiliary network means being selected to define said at least one desired locus in the complex impedance plane, the locus representing the condition of zero difference between the values respectively in the two states of a respective one of the two parameters,

thereby indicating that said R.F. impedance does or does not lie substantially on a said locus according as there is not or there is, respectively, a substantial difference between the values of the respective parameter in two states. The invention further relates to R.F. apparatus comprising such a network and such an arrangement for deriving such information.

The network may be the combination of an antenna and an antenna tuning unit, the antenna tuning unit having two ports one of which is connected to the antenna (which acts as a source of R.F. signals) and information being desired of the impedance presented by the combination at the other port; the invention may be used in matching the antenna to a radio receiver or transmitter.

A method and an arrangement as set forth in the opening paragraph are known from DE—B—2 044 500 which discloses a method of checking the matching of the combination of an antenna and an antenna tuning unit, using signals received by the antenna. The disclosed method involves connecting various loads in shunt with a direct connection from the antenna tuning unit to a radio receiver, and comparing the amplitudes and/or phases of the resultant signals in the receiver. The loads mentioned in the specification comprise an open-circuit, a short-circuit, a purely real load, a purely inductive load and a purely capacitive load. The method of checking whether the antenna is correctly matched generally involves comparing the amplitudes of the voltages in the receiver when the shunt load is respectively an open-circuit and a purely real impedance equal to the desired match impedance; the impedance presented by the combination of the antenna and the antenna tuning unit lies on a circle passing through the desired match point when the amplitudes are in the ratio of 2:1, i.e. the amplitudes are different in the two states and their numerical ratio must be ascertained. The specification mentions (see generally column 6, line 12 to column 7, line 2, and particularly column 6, lines 48—55) that a complex mismatch can be detected by measuring the phase change between no load and a real load. This implies that when there is no difference between the phases in the two states, the impedance being checked lies on the real axis in the complex impedance plane. The specification also mentions (see generally column 7, line 14 to column 8, line 27 and particularly column 7, line 64 to column 8, line 8) that in addition to the above-mentioned amplitude comparison, one may compare the amplitudes of the signals obtained with a purely inductive load and a purely capacitive load, the magnitudes of the reactances of these two loads being equal at the frequency of the test signal. When these two amplitudes are equal to one another, the impedance being checked is real, i.e. it again lies on the real axis in the complex impedance plane. These two cases of no phase difference and no amplitude difference respectively therefore enable impedance information to be derived in relation to one particular locus in the complex impedance plane.

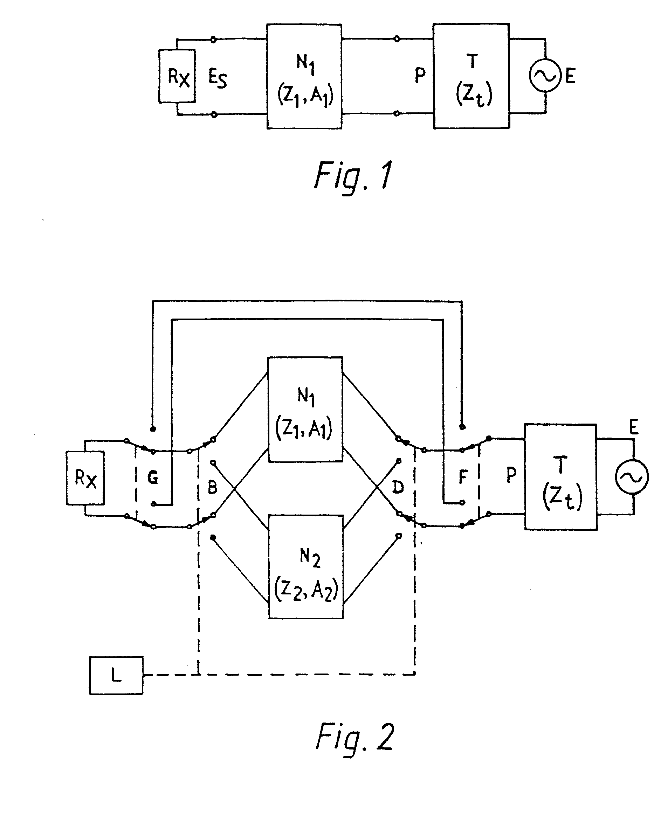

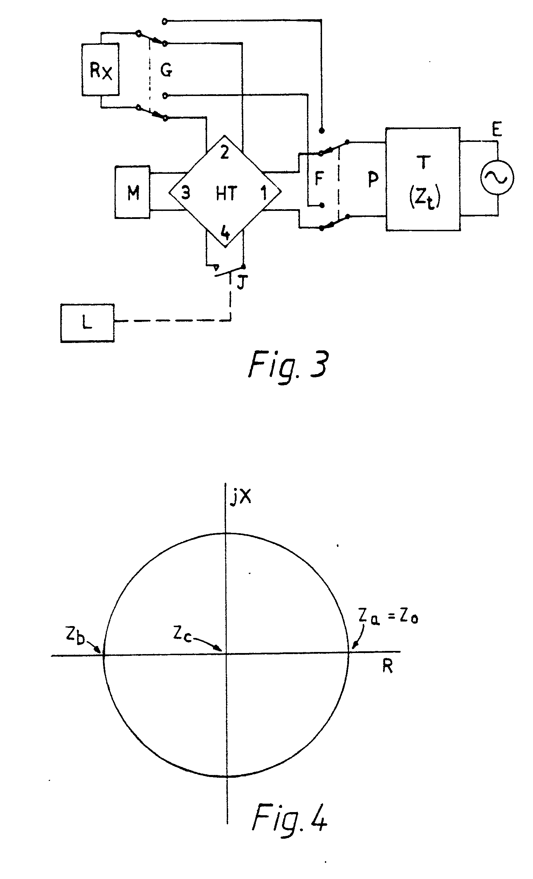

It may be mentioned that GB—A—1 565 166 discloses a method and an arrangement which have features set forth in the opening paragraph of this specification, but which differ from that method and arrangement in that the source of RF signals which supplies the reference signal utilised in deriving the impedance information is included in the arrangement which is connected to said port of the network, rather than being included in the network itself. Furthermore, the axiliary network means comprise two auxiliary networks whose selected characteristics, with regard to the configuration of Figure 1, are that one is a potential divider and the other a current transformer providing signals respectively representative of the voltage across and the current flowing through said port when the source supplies a signal to the combination of the auxiliary network means and the indicating means, and thence to the main network; at least as regards the current transformer auxiliary network, the source is coupled thereto at a different port thereof from the main network and the indicating means. It may be mentioned that similar auxiliary networks are used in the configuration of Figure 3, but in this case as a voltage transducer and a current transducer for injecting signals from the source, and impedance loci are defined by selecting the ratios of carrier levels and modulation factors of signals respectively injected by the two transducers.

It is an object of the invention to provide a method and an arrangement as set forth in the opening paragraph which enable information of

2

the value of the R.F. impedance of a network to be derived in relation to any one or two of a range of desired loci in the complex impedance plane, using indicating means which of course are of adequate sensitivity to respond to R.F. signals from the source (and provided the signal-to-noise ratio is also adequate).

According to a first aspect of the invention, a method as set forth in the opening paragraph is characterised in that the values $Z_1$, $Z_2$ of the impedance presented by the arrangement at said port respectively in the two states, $Z_1$ differing from $Z_2$, and the values $A_1$, $A_2$ of the gain provided between said port and the indicating means by the auxiliary network means respectively in the two states, $A_1$ differing from $A_2$, are selected to define either the desired locus or two desired loci in the complex impedance plane so that the absence of any difference between the respective values in the two states of the amplitude indicates that the value $Z_t$ of said R.F. impedance satisfies the equation

$$ | A_1Z_1/(Z_t+Z_1) | = | A_2Z_2/(Z_t+Z_2)| $$

and/so so that the absence of any difference between the respective values in the two states of the phase indicates that the value $Z_t$ of said R.F. impedance satisfies the equation

$$ arg(Z_t+Z_1)=arg(Z_t+Z_2)+arg\ A $$

where
$$ A=A_1Z_1/A_2Z_2. $$

According to a second aspect, the invention provides R.F. apparatus comprising an electrical network and an arrangement for deriving information of the value of the R.F. impedance $Z_t$ presented by the network at a port thereof in relation to at least one desired locus in the complex impedance plane, wherein the network comprises a source of R.F. signals for supplying a reference signal utilised in deriving said information, wherein said arrangement comprises network means auxiliary to the network of whose R.F. impedance $Z_t$ it is desired to derive information and further comprises indicating means responsive to R.F. signals, wherein the arrangement is operable to be connected to said port successively in two different states and to indicate with the indicating means whether there is any difference between the respective values in the two states of at least one of the two parameters, amplitude and phase respectively, of the signal supplied to the indicating means when the reference signal is supplied to said arrangement by the source, characteristics of the auxiliary network means being selected to define said at least one desired locus in the complex impedance plane, the locus representing the condition of zero difference between the values respectively in the two states of a respective one of the two parameters, thereby indicating that said R.F. impedance $Z_t$ does or does not lie substantially on a said locus according as there is not or there is, respectively, a substantial difference between the values of the respective parameter in the two states,

characterised in that the values $Z_1$, $Z_2$ of the impedance presented by the arrangement at said port respectively in the two states, $Z_1$ differing from $Z_2$, and the values $A_1$, $A_2$ of the gain provided between said port and the indicating means by the auxiliary network means respectively in the two states, $A_1$ differing from $A_2$, have been selected to define either the desired locus or two desired loci in the complex impedance plane so that the absence of any difference between the respective values in the two states of the amplitude indicates that the value $Z_t$ of said R.F. impedance satisfies the equation

$$ | A_1Z_1/(Z_t+Z_1) | = | A_2Z_2/(Z_t+Z_2) | $$

and/or so that the absence of any difference between the respective values in the two states of the phase indicates that the value $Z_t$ of said R.F. impedance satisfies the equation

$$ arg\ (Z_t+Z_1)=arg\ (Z_t+Z_2)+arg\ A $$

where
$$ A=A_1Z_1/A_2Z_2. $$

In the above-mentioned method and arrangement disclosed in DE—B—2 044 500 involving the two cases of no phase difference and no amplitude difference respectively, each of the loads used in deriving impedance information is in shunt with a direct connection from the port of the network under test to the indicating means, and consequently the gain between said port and the indicating means is in each case unity. By contrast, in methods and arrangements embodying the present invention, different gains are used in the two states in which the values of amplitude and/or phase are compared. This allows a range of different desired loci in the complex impedance plane to be defined.

The values $Z_1$, $Z_2$, $A_1$, $A_2$ may be predetermined or, as an alternative, be selected in use. They may be selected to the extent that a said locus passes through a desired point in the complex impedance plane, or as an alternative, that a said locus at least approximates a boundary of a region of the complex impedance plane representing a condition which it is desired said R.F. impedance should satisfy, for example the condition that the impedance or a parameter dependent thereon should be not less than or not greater than a particular value. Accordingly, where said R.F. impedance of the network is adjustable, the values $Z_1$, $Z_2$, $A_1$, $A_2$ being selected so that a said locus at least approximates a boundary of a particular region of the complex impedance plane representing a condition which it is desired said R.F. impedance should satisfy and the indicating means being operable to distinguish between impedances in regions of the complex impedance plane separated by said locus, the method may further comprise adjusting said R.F. impedance to bring it within said particular region. As an alternative, where said R.F. impedance of the network is adjustable, the values $Z_1$, $Z_2$, $A_1$, $A_2$ being selected to define two loci respectively of zero difference between the values of the two parameters such that the loci intersect at a point in the complex impedance plane representing a desired value for said R.F. impedance, the method may further comprise adjusting said R.F. impedance to make any said difference substantially zero for each parameter whereby substantially to equate said R.F. impedance with the desired value.

The indicating means preferably comprise a radio receiver. This can provide particularly good sensitivity, while the selectivity of the receiver can be used to exclude unwanted signals (including noise) and can enable information of said R.F. impedance readily to be derived substantially at a selected frequency of interest.

Preferably, the method comprises switching the arrangement alternately to one state and the other, and the indicating means are used to indicate any said difference by indicating the presence of at least one of the two modulations, amplitude modulation and phase modulation respectively, in the signal supplied to it. This is particularly suitable for performing the invention with a radio receiver.

The indicating means may for example comprise means for deriving an amplitude-demodulated signal from the signal supplied thereto: this can enable it to indicate differences in the values of both parameters, as explained hereinafter. The switching from one state to the other may be performed at a frequency in the audible range, and the amplitude-demodulated signal fed to an audio-frequency reproducer to provide an audible indication.

The method may comprise deriving a demodulated signal in the indicating means from the signal supplied thereto and detecting the demodulated signal synchronously with the switching to one state and the other whereby to distinguish between impedance in regions of the complex impedance plane separated by the respective locus.

The method may comprise deriving in the indicating means from the signal supplied thereto a signal at an intermediate frequency and deriving therefrom an amplitude-demodulated signal, and further comprise performing the switching at a frequency not substantially more than a quarter of the intermediate frequency bandwidth of the indicating means whereby a component of said amplitude-demodulated signal at twice the switching frequency indicates the presence of phase modulation.

Claims 8 and 9 define optional features of apparatus embodying the invention.

The auxiliary network means suitably comprise a hydbrid device having four ports, wherein in each state a first port of the device is coupled to said port of the electrical network, a second port is coupled to the indicating means and a third port is terminated with a selected impedance, wherein the fourth port is terminated with different respective impedances in the two states, and wherein when said R.F. impedance $Z_t$ and said selected impedance satisfy a predetermined condition, the second and fourth ports are isolated from one another. This is particularly simple and compact and is especially suitable when it is desired substantially to equate said R.F. impedance of the combination with a standard value since the selected impedance terminating the third port may then simply be a matched load. As an alternative, the selected impedance may have different respective values in the two states. The different respective impedances terminating the fourth port may be an open-circuit and a short-circuit respectively.

When the invention is applied to the process of matching an antenna to a radio receiver or to a radio transmitter-receiver combination, it has the advantage that during the matching process the receiver is connected to the antenna for radio reception and can thus continue to receive radio transmissions (albeit possibly at a lower level than usual owing to attenuation by passive auxiliary network means) since it is such transmissions which produce in the antenna the signals used to derive the R.F. impedance information; similar considerations apply to the use of the invention in matching a carrier telephone receiver to a cable with an adjustable equalizer.

The invention will now be further explained and embodiments thereof described by way of example with reference to the accompanying diagrammatic drawings, in which:—

Figure 1 is an equivalent circuit of a circuit configuration used in embodiments of the invention;

Figure 2 illustrates a first embodiment of the invention;

Figure 3 illustrates a second embodiment of the invention, and

Figure 4 shows a locus in the complex impedance plane.

Referring to Figure 1, an electrical network including a source of R.F. signals, for example an antenna tuning network in series with an antenna, is represented by a two-port network T having a R.F. voltage source E connected across one port and presenting at its second port P an impedance $Z_t$; this is the impedance of which it is desired to obtain information. A two-port auxiliary network $N_1$ has one port connected to the port P of network T, and a radio receiver Rx is connected across its other port so that the network $N_1$ is in cascade between port P of network T and the receiver Rx. This combination of $N_1$ and Rx presents at port P an impedance $Z_1$; the auxiliary network $N_1$ provides between port P and Rx a gain (or transmissivity) $A_1$, which in the case of a passive auxiliary network will usually be less than unity. The voltage $E_s$ across the receiver Rx is given by

$$E_s = E \cdot A_1 \cdot Z_1/(Z_t + Z_1) \qquad (i)$$

The radio receiver Rx may be associated with a radio transmitter (not shown).

Figure 2 shows arrangement comprising a pair of auxiliary networks $N_1$ and $N_2$ respectively and a radio receiver Rx. By means of two electronic or electro-mechanical switches B and D, the arrangement can be coupled to port P of network T in two different states in which a respective one of the auxiliary networks $N_1$ and $N_2$ is in cascade between port P and receiver Rx, in which the arrangement presents at port P different respective impedances $Z_1$ and $Z_2$, and in which the respective cascaded auxiliary network provides between port P and the receiver different respective gains $A_1$ and $A_2$. The arrangement also includes a generator L which applies a square-wave switching waveform to switches B and D so that the receiver Rx is coupled to port P alternately via one network and the other.

The signals supplied to the receiver Rx via networks $N_1$ and $N_2$ respectively will be of equal amplitudes when, from equation (i),

$$|A_1 Z_1/(Z_t + Z_1)| = |A_2 Z_2/C_t + Z_2)| \qquad (ii)$$

assuming the source voltage to be the same in the two states of the arrangement as for example when a radio signal of steady carrier amplitude is incident upon an antenna. From this we may write

$$|Z_t + Z_1| = |A| \cdot |Z_t + Z_2| \qquad (iii)$$

where

$$A = A_1 Z_1/A_2 Z_2. \qquad (iv)$$

The values of $Z_t$ which satisfy equation (iii) lie on a locus in the complex impedance plane (impedances in this plane being defined, for example, with reference to mutually orthogonal axes representing purely real and purely imaginary impedances): this locus is a circle with its centre on the straight line passing through $Z_1$ and $Z_2$ and intersecting this line at points $Z_a$ and $Z_b$ given by

$$Z_a = (|A|Z_2 - Z_1)/(1 - |A|) \qquad (v)$$

and

$$Z_b = (-|A|Z_2 - Z_1)/(1 + |A|); \qquad (vi)$$

the centre of the circle is at

$$Z_c = (|A|^2 Z_2 - Z_1)/(1 - |A|^2). \qquad (vii)$$

The values of $Z_1$, $Z_2$, $A_1$ and $A_2$ may be selected so that the locus defined by equation (iii) at least approximates a boundary of a region of the complex impedance plane representing a condition which it is desired $Z_t$ should satisfy: the condition may for example be that $Z_t$, or the real part of $Z_t$, or the conductance corresponding to $Z_t$, or the VSWR resulting from $Z_t$, is not less than or not greater than, a particular value. Where (as

here) $Z_t$ is adjustable it may be desired to adjust $Z_t$ to bring it within said region of the complex impedance plane.

Alternatively or in addition, the values of $Z_1$, $A_2$, $A_1$ and $A_2$ may be selected so that the point $Z_a$ is at particular point $Z_o$: from equation (v), the relevant condition is

$$|A| = (Z_o + Z_1)/(Z_o + Z_2) \qquad (viii)$$

Furthermore, there will be no difference in the phases of signals supplied to the receiver via networks $N_1$ and $N_2$ relative to a signal of reference phase at the source when, from equations (i) and (iv),

$$\arg(Z_t + Z_1) = \arg(Z_t + Z_2) + \arg A \qquad (ix)$$

This equation defines a further locus for $Z_t$ in the complex impedance plane. If $Z_1$, $Z_2$ and A are wholly real and positive, this locus is the real axis in the complex impedance plane and of course passes through $Z_1$ and $Z_2$. Thus, if $Z_1$, $Z_2$, $A_1$, and $A_2$ are selected to satisfy this condition and also equation (viii) above, the loci defined by equation (iii) and (ix) will intersect at the point $Z_o$ on the real axis. Hence the impedance $Z_t$ can be equated with $Z_o$ if $Z_t$ is adjusted until the receiver indicates that there is no difference in the amplitudes and no difference in the phases of the signals supplied to the receiver Rx in the two different states of the arrangement.

Whether there is or is not any difference in the amplitudes of the signals can readily be indicated by switching the arrangement between the two states by means of the generator L, as shown in Figure 2, and using the radio receiver to indicate whether there is or is not respectively any amplitude modulation at the fundamental switching frequency present in the signal supplied to it, suitably by amplitude-demodulating the signal. If the generator L is set to switch at a frequency in the audible range, the amplitude-demodulated signal may be fed to a sound reproducer (any necessary amplification being provided) so that the presence of amplitude modulation will be indicated by an audible signal which is a reproduction of the fundamental switching frequency.

The sense of any amplitude modulation will depend on which side of the locus defined by equation (iii) the impedance $Z_t$ lies, i.e. in which of the regions of the complex impedance plane separated by the locus the impedance $Z_t$ lies. Impedances on opposite sides of the locus can be distinguished by detecting the amplitude-demodulated signal synchronously with the switching of the arrangement, i.e. when the arrangement is in one and the other state.

Whether there is any difference in the phases of the signals supplied to the receiver in the two states, relative to a reference phase at the source, may be indicated by indicating whether there is any phase modulation present. This too may be done by amplitude-demodulating the signals in the receiver, since although the different phases would not *per se* result in any difference in amplitude in the two states, the instantaneous change in phase at each moment of switching from one state to the other will cause amplitude variations at twice the switching frequency, which can be detected in the receiver if the switching frequency is less than about one quarter of the intermediate-frequency bandwidth of the receiver. Thus a radio receiver designed to respond only to amplitude modulation may also be used to indicate the presence of phase modulation.

As with amplitude modulation, the sense of any phase modulation will depend on which side of the relevant locus (defined by equation (ix)) the impedance $Z_t$ lies. Impedances on opposite side of the locus can be distinguished by using a receiver designed to respond to frequency or phase modulation and synchronously detecting the demodulated signal.

Where the electrical network represented by the voltage source E and the network T is an antenna and an antenna tuning unit, the invention being used to match the antenna to a desired impedance at a particular frequency, it will after performing the matching process be desirable to connect port P directly to the radio receiver Rx (or to an associated radio transmitter) using switches F and G shown in Figure 2. Where the antenna is to be used with a radio transmitter, $Z_o$ will usually be the output impedance of the transmitter, which impedance may be (but is not necessarily) the input impedance of the receiver.

The port of a network in relation to which R.F. impedance information is derived by the invention need not be a port which constitutes an output port of the network in normal use (as has been indicated above) but may be a port specifically provided within a circuit configuration for the purpose of deriving R.F. impedance information. For example, an antenna tuning unit may be provided with an additional port between two successive reactances of the unit so that the effect of altering the one of those reactances which is between the additional port and the antenna may be more readily ascertained.

Figure 3 illustrates an embodiment in which an arrangement comprising a four-port hybrid transformer HT and a radio receiver Rx can be coupled to port P of network T in either of two states simply by terminating one port of the hybrid device with two different respective impedances. Port 1 of the device can be coupled to port P via switch F, port 2 can be coupled to the receiver via switch G, port 3 is terminated with a selected impedance, and port 4 is terminated with the two different impedances respectively in the two states. In this case, the hybrid transformer is a symmetrical 3dB type having a characteristic impedance $Z_o$, the selected impedance terminating the third port is a matched load M (for both states of the arrangement) and the two impedances at port 4 are respectively an open-circuit and a short-circuit, as determined by a switch J controlled by a square-wave switching waveform from generator L. It may be seen that in this case, when the impedance $Z_t$ presented to port 1 also constitutes a matched load (i.e. has an impedance $Z_o$), ports 2 and 4 are isolated from each other and the variation of the termination at port 4 from one state to the other will not affect the signals supplied to the receiver. More generally, there will be a predetermined condition which the impedances terminating ports 1 and 3 must satisfy for ports 2 and 4 to be isolated from each other.

Analysis of the arrangement of Figure 3 shows that for the two states,

$$Z_1 = Z_o/3$$

$$Z_2 = 3Z_o$$

and

$$A = 1/3.$$

The locus for $Z_t$ in the complex impedance plane for no difference in the amplitudes of the signals supplied to the receiver in the two states is a circle centred at the origin and passing through the point $Z_a = Z_o$, as shown in Figure 4.

If a least one of the two impedances respectively terminating port 4 in the two states is changed from the values indicated above, the radius and the position of the centre of the circle will be altered, but the circle will still pass through the point $Z_o$.

The impedance selected to terminate port 3 may be a single impedance other than a matched load, in which case there will be no differences in the amplitudes and phases of the signals supplied to the receiver when $Z_t$ is the complex conjugate of that single impedance. As a further alternative, the impedance terminating port 3 may have different respective values in the two states: for that purpose, a further switch may be provided at port 3 and be controlled by generator L in synchronism with switch J at port 4.

A hybrid transformer which has been found suitable for the arrangement of Figure 3 is a broad-band (2—200 MHz) device type THV 50 having a characteristic impedance of 50 ohms, made by ANZAC (a U.S. company). This device includes a matched load terminating one port.

The hybrid device need not be a symmetrical 3dB type. For example, a device giving unequal power division may give a signal which is weaker than that with a 3dB type but which is more heavily modulated when at least one of the parameters has unequal values in the two states.

Although embodiments of the invention have been specifically described above with a radio receiver as the radio indicating means, it is possible to use any device which is suitable for indicating any difference in the values of amplitude and/or phase of the signal supplied thereto (relative to a signal of reference amplitude and phase respectively at the source) in the two different states and which is appropriate to the particular process of indication, e.g. modulation resulting from switching between the two states (as described above) or a direct comparison of the values.

## Claims

1. A method of deriving information of the value of the R.F. impedance $Z_t$ presented by an electrical network, (T, E) at a port (P) thereof in relation to at least one desired locus in the complex impedance plane, utilising a reference signal supplied by a source (E) of R.F. signals that is included in the network (T, E) and using an arrangement which comprises network means $(N_1, N_2)$ auxiliary to the network (T, E) of whose R.F. impedance $Z_t$ it is desired to derive information and which further comprises indicating means (Rx) responsive to R.F. signals, the method comprising:—

connecting said arrangement to said port (P) successively in two different states, and using the indicating means (Rx) to indicate whether there is any difference between the respective values in the two states of a least one of the two parameters, amplitude and phase respectively, of the signal supplied to the indicating means (Rx) when the reference signal is supplied to said arrangement by the source (E),

characteristics of the auxiliary network means $(N_1, N_2)$ being selected to define said at least one desired locus in the complex impedance plane, the locus representing the condition of zero difference between the values respectively in the two states of a respective one of the two parameters,

thereby indicating that said R.F. impedance $Z_t$ does or does not lie substantially on a said locus according as there is not or there is, respectively, a substantial difference between the values of the respective parameter in the two states,

characterised in that the values $Z_1$, $Z_2$ of the impedance presented by the arrangement at said port (P) respectively in the two states, $Z_1$ differing from $Z_2$, and the values $A_1$, $A_2$ of the gain provided between said port (P) and the indicating means (Rx) by the auxiliary network means $(N_1, N_2$ respectively) respectively in the two states, $A_1$ differing from $A_2$, are selected to define either the desired locus or two desired loci in the complex impedance plane so that the absence of any difference between the respective values in the two states of the amplitude indicates that the value $Z_t$ of said R.F. impedance satisfies the equation

$$| A_1 Z_1/(Z_t+Z_1) | = | A_2 Z_2/(Z_t+Z_2) |$$

and/or so that the absence of any difference between the respective values in the two states of the phase indicates that the value $Z_t$ of said R.F. impedance satisfies the equation

$$\arg (Z_t+Z_1)=\arg (Z_t+Z_2)+\arg A$$

where
$$A=A_1 Z_1/A_2 Z_2.$$

2. A method as claimed in claim 1 wherein said R.F. impedance $Z_t$ of the network (T, E) is adjustable, the values $Z_1$, $Z_2$, $A_1$, $A_2$ being selected so that a said locus at least approximates a boundary of a particular region of the complex impedance plane representing a condition which it is desired said R.F. impedance $Z_t$ should satisfy and the indicating means (Rx) being operable to distinguish between impedances in regions of the complex impedance plane separated by said locus, the method further comprising adjusting said R.F. impedance $Z_t$ to bring it within said particular region.

3. A method as claimed in Claim 1 wherein said R.F. impedance $Z_t$ of the network (T, E) is adjustable, the values $Z_1$, $Z_2$, $A_1$, $A_2$ being selected to define two loci respectively of zero difference between the values of the two parameters such that the loci intersect at a point in the complex impedance plane representing a desired value for said R.F. impedance $Z_t$, the method further comprising adjusting said R.F. impedance $Z_t$ to make any said difference substantially zero for each parameter whereby substantially to equate said R.F. impedance $Z_t$ with the desired value.

4. A method as claimed in any preceding Claim which comprises switching the arrangement alternately to one state and the other wherein the indicating means (Rx) are used to indicate any said difference by indicating the presence of at least one of the two modulations, amplitude modulation and phase modulation respectively, in the signal supplied to it.

5. A method as claimed in Claim 4 which comprises deriving a demodulated signal in the indicating means (Rx) from the signal supplied thereto and detecting the demodulated signal synchronously with the switching to one state and the other whereby to distinguish between impedances in regions of the complex impedance plane separated by the respective locus.

6. A method as claimed in Claim 4 or 5 which comprises deriving in the indicating means (Rx) from the signal supplied thereto a signal at an intermediate frequency and deriving therefrom an amplitude-demodulated signal, and which further comprises performing the switching at a frequency not substantially more than a quarter of the intermediate frequency bandwidth of the indicating means (Rx) whereby a component of said amplitude-demodulated signal at twice the switching frequency indicates the presence of phase modulation.

7. R.F. apparatus comprising an electrical network (T, E) and an arrangement for deriving information of the value of the R.F. impedance $Z_t$ presented by the network (T, E) at a port (P) thereof in relation to at least one desired locus in the complex impedance plane, wherein the network (T, E) comprises a source (E) of R.F. signals for supplying a reference signal utilised in deriving said information, wherein said arrangement comprises network means $(N_1, N_2)$ auxiliary to the network (T, E) of whose R.F. impedance $Z_t$ it is desired to derive information and further comprises indicating means (Rx) responsive to R.F. signals, wherein the arrangement is operable to be connected to said port (P) successively in two different states and to indicate with the indicating means (Rx) whether there is any difference between the respective values in the two states of at least one of the two parameters, amplitude and phase respectively, of the signal supplied to the indicating means (Rx) when the reference signal is supplied to said arrangement by the source (E), characteristics of the auxiliary network means $(N_1, N_2)$ being selected to define said at least one desired locus in the complex impedance plane, the locus representing the condition of zero difference between the values respectively in the two states of a respective one of the two parameters, thereby indicating that said R.F. impedance $Z_t$ does or does not lie substantially on a said locus according as there is not or there is, respectively, a substantial difference between the values of the respective parameter in the two states,

characterised in that the values $Z_1$, $Z_2$ of the impedance presented by the arrangement at said port (P) respectively in the two states, $Z_1$ differing from $Z_2$, and the values $A_1$, $A_2$ of the gain provided between said port (P) and the indicating means (Rx) by the auxiliary network means $(N_1, N_2$ respectively) respectively in the two states, $A_1$ differing from $A_2$, have been selected to define either the desired locus or two desired loci in the complex impedance plane so that the absence of any difference between the respective values in the two states of the amplitude indicates that the value $Z_t$ of said R.F. impedance satisfies the equation

$$| A_1 Z_1 / (Z_t + Z_1) | = | A_2 Z_2 / (Z_t + Z_2) |$$

and/or so that the absence of any difference between the respective values in the two states of the phase indicates that the value $Z_t$ of said R.F. impedance satisfies the equation

$$\arg (Z_t + Z_1) = \arg (Z_t + Z_2) + \arg A$$

where

$$A = A_1 Z_1 / A_2 Z_2.$$

8. Apparatus as claimed in Claim 7 comprising means (B, D) for switching the arrangement alternately to one state and the other.

9. Apparatus as claimed in Claim 8 wherein the indicating means (Rx) comprises means for deriving a demodulated signal from the signal supplied thereto and for detecting the demodulated signal synchronously with the switching to one state and the other.

10. Apparatus as claimed in any of Claims 7 to 9 wherein the auxiliary network means $(N_1, N_2)$ comprise a hybrid device (HT) having four ports (1, 2, 3, 4), wherein in each state a first port (1) of the device (HT) is coupled to said port (P) of the electrical network (T, E), a second port (2) is coupled to the indicating means (Rx) and a third port (3) is terminated with a selected impedance (M), wherein the fourth port (4) is terminated with different respective impedances in the two states, and wherein when said R.F. impedance $Z_t$ and said selected impedance (M) satisfy a predetermined condition, the second and fourth ports (2, 4) are isolated from each other.

11. Apparatus as claimed in Claim 10 wherein the selected impedance (M) terminating the third port (3) has different respective values in the two states.

12. Apparatus as claimed in Claim 10 or 11 wherein the different respective impedances terminating the fourth port (4) are an open-circuit and a short circuit respectively.

## Patentansprüche

1. Verfahren zum Ableiten von Information aus dem Wert der HF-Impedanz $Z_t$, die von einem Elektischen Netzwerk (T, E) an einem Tor (P) desselbein in bezug auf mindestens eine gewünschte Ortskurve in der komplexen Impedanzebene angeboten wird, wobei ein Bezugsignal verwendet wird, das von einer HF-Signalquelle (E) geliefert wird, die in dem Netzwerk (T, E) vorhanden ist und wobei eine Anordnung verwendet wird, die Netzwerkmittel $(N_1, N_2)$, zusätzlich zu dem Netzwerk (T, E) aufweist, auf dessen HF-Impedanz $Z_t$ man Information erhalten will und das weiterhin Anzeigemittel (Rx) aufweist, die von HF-Signalen beeinflusst werden, wobei das Verfahren die folgenden Schritte umfasst: das Verbinden der genannten Anordnung mit dem genannten Tor (p) nacheinander in zwei verschiedenen Zuständen und das Verwenden der Anzeigemittel (Rx) um anzuzeigen, ob es einen Unterscheid zwischen den betreffenden Werten in den zwei Zuständen wenigstens eines der zwei Parameter, d.h. Amplitude bwz. Phase, des den Anzeigemitteln (Rx) zugeführten Signals gibt, wenn das Bezugssignal von der Quelle (E) der genannten Anordnung zugeführt wird, das Selektieren von Kenzeichen der zusätzlichen Netzwerkmittel $(N_1, N_2)$ zum Definieren wenigstens einer gewünschten Ortskurve in der komplexen Impedanzebene, wobei die Ortskurve den Zustand einer Nulldifferenz zwischen den betreffenden Werten in den zwei Zuständen einer betreffenden der Zwei Parameter angibt, wobei angezeigt wird, dass die genannte HF-Impedanz ZT ggf. im wesentlichen auf der genannten Ortskurve liegt und zwar in übereinstimmung damit, ob es wohl oder nicht zwischen den Werten des betreffenden Parameters in den zwei Zuständen eine wesentliche Differenz gibt, dadurch gekennzeichnet, dass die Werte $Z_1$, $Z_2$ der von der Anordnung an dem betreffenden Tor (P) in den zwei Zuständen angebotenen Impedanz, wobei $Z_1$ anders ist als $Z_2$, und die Werte $A_1$, $A_2$ der zwischen dem genannten Tor (P) und den Anzeigemitteln (Rx) von den Hilfsnetzwerkmitteln $(N_1$ bzw. $N_2)$ in den betreffenden zwei Zuständen, wobei $A_1$ anders ist als $A_2$, gelieferten Impedanz selektiert werden zum Bestimmen der gewünschten Ortskurve oder zweier gewünschter Ortskurven in der komplexen Impedanzebene, so dass das Fehlen einer Differenz zwischen den betreffenden Werten in den zwei Zuständen der Amplitude anzeigt, dass der Wert $Z_t$ der genannten HF-Impedanz die folgende Gleichung erfüllt:

$$| A_1 Z_1/(Z_t+Z_1) | = | A_2 Z_2/(Z_t+Z_2) |$$

und/oder so dass das Fehlen einer Differenz zwischen den betreffenden Werten in den zwei Zuständen der Phase angibt, dass der Wert $Z_t$ der genannten HF-Impedanz die folgende Gleichung erfüllt:

$$arg \ (Z_t+Z_1)=arg \ (Z_t+Z_2)+arg \ A$$

wobei

$$A=A_1 Z_1/A_2 Z_2 \ ist.$$

2. Verfahren nach Anspruch 1, dadurch gekennzeichnet, dass die genannte HF-Impedanz $Z_t$ des Netzwerkes (T, E) einstellbar ist, wobei die Werte $Z_1$, $Z_2$, $A_1$, $A_2$ derart selektiert werden, dass eine genannte Ortskurve wenigstens einer Grenze eines bestimmten Gebietes der komplexen Impedanzebene annähert, die einen Zustand darstellt, von dem erwünscht wird, dass er von der genannten HF-Impedanz $Z_t$ erfüllt wird und wobei die Anzeigemittel (Rx) zwischen Impedanzen in Gebieten der komplexen Impedanzebene, die durch die genannte Ortskurve getrennt sind unterscheiden, wobei das Verfahren weiterhin das Einstellen der genannten HF-Impedanz $Z_t$ umfasst um diese in das genannte bestimmte Gebiet zu bringen.

3. Verfahren nach Anspruch 1, dadurch gekennzeichnet, dass die genannte HF-Impedanz $Z_t$ des Netzwerkes (T, E) einstellbar ist, wobei die Werte $Z_1$, $Z_2$, $A_1$, $A_2$ selektiert werden um zwei Ortskurven einer Nulldifferenz zwischen den Werten der zwei Parameter derart zu definieren, dass die Ortskurven sich an einem Punkt in der komplexen Impedanzebene schneiden, der einen gewünschte Wert für die genannte HF-Impedanz $Z_t$ darstellt, wobei das Verfahren weiterhin das Einstellen der genannten HF-Impedanz $Z_t$ umfasst um jede genannte Differenz für jeden Parameter nahezu Null zu machen, wodurch die genannte HF-Impedanz $Z_t$ mit dem gewünschten Wert nahezu gleichgesetzt wird.

4. Verfahren nach einem der vorstehenden Ansprüche, das das wechselweise Umschalten der Anordung vom einem Zustanden in den anderen umfasst, dadurch gekennzeichnet, dass die Anzeigemittel (Rx) zum Anzeigen einer Differenz verwendet werden in dem das Vorhandensein wenigstens einer der zwei Modulationen, d.h. Amplitudemodulation bzw. Phasenmodulation, in dem den Mitteln angebotenen Signal angezeigt wird.

5. Verfahren nach Anspruch 4, das das Ableiten eines demodulierten Signals in den Anzweigemitteln (Rx) aus dem denselben angebotenen Signal und das Detektieren des demodulierten Signals synchron zu dem in den einen und in den anderen Zustand Schalten umfasst, wodurch zwischen Impedanzen in Gebieten der komplexen Impedanzebene, die durch die betreffende Ortskurve voneinander getrennt sind, unterschieden werden kann.

6. Verfahren nach Anspruch 4 oder 5, das das in den Anzeigemitteln (Rx) aus dem denselben zugeführten Signal Ableiten eines Signals mit einer Mittelfrequenz und das aus demselben Ableiten eines amplitudendemodulierten Signals umfasst, und das weiterhin das mit einer Frequenz, die im wesentlichen nicht mehr als ein Viertel der ZF-Bandbreite der Anzeigemittel ist, Schalten umfasst, wobei ein Anteil des genannten amplitudendemodulierten Signals mit der dopelten Schaltfrequenz das Vorhandensein einer Phasenmodulation angibt.

7. HF-Gerät mit einem elektrischen Netzwerk (T, E) und einer Anordnung zum Ableiten von Information aus dem Wert der HF-Impedanz $Z_t$, die von dem Netzwerk (T, E) an einem Tor (P) desselben in bezug auf mindestens eine gewünschte Ortskurve in der komplexen Impedanzebene angeboten wird, wobei das Netzwerk (T, E) eine Quelle (E) von HF-Signalen aufweist zum Liefern eines Bezugssignals, das beim Ableiten der genannten Information verwendet wird, wobei die genannte Anordnung Netzwerkmittel ($N_1$, $N_2$) zusätzlich zu dem Netzwerk (T, E), von dessen HF-Impedanz man Information ableiten will, aufweist und weiterhin Anzeigemittel (Rx) aufweist, die durch HF-Signale beeinflusst werden, wobei die Anordung mit dem genannten Tor (P) in zwei unterschiedlichen Zuständen verbunden werden kann und wobei mit den Anzeigemittel (Rx) angezeigt werden kann, ob es zwischen den betreffenden Werten in den zwei Zuständen wenigstens eines der zwei Parameter, Amplitude bzw. Phase, des den Anzeigemitteln (Rx) zugeführten Signals einen Unterscheid gibt, wenn das Bezugssignal von der Quelle (E) der genannten Anordnung zugefürt wird, wobei Kennzeichen der zusätzlichen Netzwerkmittel ($N_1$, $N_2$) selektiert werden um wenigstens eine gewünschte Ortskurve in der komplexen Impedanzebene zu definieren, wobei die Ortskurve, die Bedingung einer nulldifferenz zwischen den betreffenden Werten in den zwei Zuständen eines betreffenden der zwei Parameter darstellt, wobei angegeben wird, dass die genannte HF-Impedanz $Z_t$ im wesentlichen auf einer genannten Ortskurve liegt in übereinstimmung damit, ob es wohl oder nicht eine wesentliche Differenz zwischen den Werten des betreffenden Parameters in den zwei Zuständen gibt, dadurch gekennzeichnet, dass die Werte $Z_1$, $Z_2$ der Impedanz, die von der Anordnung an dem genannten Tor (P) in den zwei betreffenden Zuständen, wobei $Z_1$ anders ist als $Z_2$, angeboten wird und die Werte $A_1$, $A_2$ der zwischen dem genannten Tor (P) und den Anzeigemitteln (Rz) von den zusätzlichen Netzwerkmitteln ($N_1$ bzw. $N_2$) in den zwei betreffenden Zuständen, wonei $A_1$ anders ist $A_2$, gelieferten Verstärkung selektiert sind um die gewünschte Ortskurve oder zwei gewünschte Ortkurven in der komplexen Impedanzebene zu definieren, so dass das Fehlen einer Differenz zwischen den betreffenden Werten in den zwei Zuständen der Amplitude angibt, dass der Wert $Z_t$ der genannten HF-Impedanz die folgende Gleichung erfüllt:

$$| A_1 Z_1/(Z_t+Z_1) | = | A_2 Z_2/(Z_t+Z_2) |$$

und/oder so dass das Fehlen einer Differenz zwischen den betreffenden Werten in den zwei Zuständen der Phase angibt, dass der Wert $Z_t$ der genannten HF-Impedanz die folgende Gleichung erfüllt:

$$\arg (Z_t+Z_1)=\arg (Z_t+Z_2)+\arg A$$

worin

$$A=A_1 Z_1/A_2 Z_2 \text{ ist.}$$

8. Gerät nach Anspruch 7 mit Mitteln (B, D) zum wechselweisen Umschalten der Anordnung aus dem einen Zustand in den anderen Zustand.

9. Gerät nach Anspruch 8, dadurch gekennzeichnet, dass die Anzeigemittel (Rx) Mittel aufweisen zum Ableiten eines demodulierten Signals aus dem denselben zugeführten Signal und zum Detektieren des Demodulierten Signals synchron zu dem aus dem einen Zustand in den anderen Zustand Schalten.

10. Gerät nach einem der Ansprüche 7 bis 9, dadurch gekennzeichnet, dass die zusätzlichen Netzwerkmittel ($N_1$, $N_2$) eine Hybridanordnung (HT) mit vier Toren (1, 2, 3, 4) aufweisen, dadurch gekennzeichnet, dass in jedem Zustand ein erstes Tor (1) der Anordnung (HT) mit dem genannten Tor (P) des elektrischen Netzwerkes (T, E) gekoppelt is, ein zweites Tor (2) mit dem Anzeigemitteln (Rx) gekoppelt ist und dass ein drittes Tor (3) mit einer gewählten Impedanz (M) abgeschlosssen ist, wobei das Vierte Tor (4) mit unterschiedlichen Impedanzen in den betreffenden zwei Zuständen abgeschlossen ist und wobei das zweite und vierte Tor (2, 4) gegeneinander isoliert sind, wenn die genannte HF-Impedanz $Z_t$ und die gewählte selektierte Impedanz (M) eine vorbestimmte Bedingung erfüllen.

11. Gerät nach Anspruch 10, dadurch gekennzeichnet, dass die selektierte Impedanz (M), die das dritte Tor (3) abschliesst, in den zwei Zuständen unterscheildliche Werte hat.

12. Gerät nach Anspruch 10 oder 11, dadurch gekennzeichnet, dass die unterschiedlichen Impedanzen, die das vierte Tor (4) abschliessen, eine Leerlaufimpedanz bzw. eine Kurzschlussimpedanz sind.

## Revendications

1. Procédé pour déduire de l'information de la valeur de l'impédance en radiofréquence $Z_t$ présentée par un réseau électrique (T, E) au niveau d'un accès (P) de ce réseau par rapport à au moins un lieu souhaité dans le plan d'impédance complexe, à l'aide d'un signal de référence fourni par une source (E) de signaux de radiofréquence qui est incorporée dans le réseau (T, E) et au moyen d'un système qui comprend des réseaux ($N_1$, $N_2$) auxiliaires à l'égard du réseau (T, E) de l'impédance de radiofréquence $Z_t$ duquel on souhaite déduire de l'information et qui comprend, en outre, un dispositif indicateur (Rx) réagissant aux signaux de radiofréquence, le procédé impliquant:

la connexion du système au dit accès (P) successivement dans deux états différents et l'utilisation du dispositif indicateur (Rx) pour indiquer s'il y a une quelconque différence entre les valeurs, obtenues respectivement dans les deux états, pour au moins un des deux paramètres, à savoir l'amplitude et la phase respectivement, du signal fourni au dispositif indicateur (Rx) lorsque le signal de référence est appliqué au système par la source (E),

les caractéristiques des réseaux auxiliaires ($N_1$, $N_2$) étant choisies de manière à définir le dit au moins un lieu souhaité dans le plan d'impédance complexe, le lieu représentant la condition de différence zéro entre les valeurs obtenues respectivement dans les deux états pour le paramètre respectif parmi les deux paramètres,

indiquant ainsi que l'inpédance de radiofréquence $Z_t$ se situe ou ne se situe pas en substance sur un tel lieu selon qu'il existe ou non respectivement une différence substantielle entre les valeurs du paramètre respectif dans les deux états,

caractérisé en ce que les valeurs $Z_1$, $Z_2$ de l'impédance présentée par le système au niveau du dit accès (P) respectivement dans les deux états, $Z_1$ différant de $Z_2$, et les valeurs $A_1$, $A_2$ du gain fourni entre cet accès (P) et le dispositif indicateur (Rx) par les réseaux auxiliares ($N_1$, $N_2$ respectivement) dans les deux états, $A_1$ différant de $A_2$, sont sélectionnées pour définir le lieu souhaité ou deux lieux souhaités dans le plan d'impédance complexe, d'une manière telle que l'absence de toute différence entre les valeurs respectives dans les deux états de l'amplitude indique que la valeur $Z_t$ de l'impédance de radiofréquence satisfait à l'équation

$$| A_1 Z_1/(Z_t+Z_1) | = | A_2 Z_2/(Z_t+Z_2) |$$

et/ou d'une manière telle que l'absence de toute différence entre les valeurs respectives dans les deux états de la phase indique que la valeur $Z_t$ de l'impédance de radiofréquence satisfait à l'équation

$$\arg (Z_t+Z_1)=\arg (Z_t+Z_2)+\arg A$$

où

$$A=A_1 Z_1/A_2 Z_2.$$

2. Procédé suivant la revendication 1, dans lequel l'impédance de radiofréquence $Z_t$ du réseau (T, E) est réglable, les valeurs $Z_1$, $Z_2$, $A_1$, $A_2$ étant sélectionnées pour qu'un lieu s'approche au moins approximativement d'une limite d'une région particulière du plan d'impédance complexe représentant une condition à laquelle il est souhaitable que l'impédance de radiofréquence $Z_t$ satisfasse et le dispositif indicateur (Rx) pouvant être mis en oeuvre pour effectuer une distinction entre des impédances dans des régions du plan d'impédance complexe séparées par le lieu, le procédé comprenant, en outre, le réglage de l'impédance de radiofréquence $Z_t$ pour l'amener dans la région particulière.

3. Procédé suivant la revendication 1, dans lequel l'impédance de radiofréquence $Z_t$ du réseau (T, E) est réglable, les valeurs $Z_1$, $Z_2$, $A_1$, $A_2$, étant sélectionnées pour définir deux lieux respectivement de différence zéro entre les valeurs des deux paramètres d'une manière telle que les lieux se coupent en un point du plan d'impédance complexe représentant une valeur souhaitée pour l'impédance de radiofréquence $Z_t$, le procédé comprenant, en outre, le réglage de l'impédance de radiofréquence $Z_t$ pour rendre la différence en substance égale à zéro pour chaque paramètre de manière à égaliser en substance l'impédance de radiofréquence $Z_t$ avec la valeur souhaitée.

4. Procédé suivant l'une quelconque des revendications précédentes qui comprend la commutation du système alternativement dans un état et dans l'autre, dans lequel le dispositif indicateur (Rx) est utilisé pour indiquer toute différence en indiquant la présence d'au moins une des deux modulations, à savoir respectivement la modulation d'amplitude et la modulation de phase, dans le signal qui lui est fourni.

5. Procédé suivant la revendication 4, qui comprend la déduction d'un signal démodulé dans le dispositif indicateur (Rx) à partir du signal qui lui est fourni et la détection du signal démodulé d'une manière synchrone avec la commutation dans un état et dans l'autre de manière à effectuer une distinction entre les impédances dans les régions du plan d'impédance complexe séparées par le lieu respectif.

6. Procédé suivant la revendication 4 ou 5, qui comprend la déduction dans le dispositif indicateur (Rx), à partir du signal qui lui est fourni, d'un signal à une fréquence intermédiaire et la déduction à partir de ce dernier signal, d'un signal dè modulé en amplitude, et qui comprend, en outre, l'exécution de la commutation à une fréquence qui ne soit pas ssnsiblement supérieure au quart de la largeur de bande du dispositif indicateur (Rx) à la fréquence intermédiaire, de sorte qu'une composante du signal démodulé en amplitude au double de la fréquence de commutation indique la présence de modulation de phase.

7. Appareil à radiofréquence comprenant un réseau électrique (T, E) et un système pour dériver de l'information au sujet de la valeur de l'impédance de radiofréquence $Z_t$ présentée par la réseau (T, E) au niveau d'un accès (P) de ce réseau en rapport avec au moins un lieu souhaité dans le plan d'impédance complexe, dans lequel le réseau (T, E) comprend une source (E) de signaux de rediofréquence pour fournir un signal de référence utilisé pour déduire l'information, dans lequel le système comprend des réseaux auxiliaires ($N_1$, $N_2$) à l'égard du réseau (T, E) de l'impédance de radiofréquence $Z_t$ duquel on souhaite déduire de l'information et comprend, en outre, un dispositif indicateur (Rx) réagissant aux signaux de radiofréquence, dans lequel le système peut être mis en oeuvre en vue d'être connecté au dit accès (P) successivement dans deux états différents et en vue d'indiquer avec le dispositif indicateur (Rx) s'il existe une différence quelconque entre les valeurs respectives dans les deux états d'au moins un des deux paramètres, à savoir l'amplitude et la phase respectivement, du signal fourni au dispositif indicateur (Rx) lorsque le signal de référence est appliqué au système par la source (E), les caractéristiques des réseaux auxiliaires ($N_1$, $N_2$) étant choisies de manière à définir au moins un lieu souhaité dans le plan d'impédance complexe, le lieu représentant la condition de différence zéro entre les valeurs respectivement dans les deux étants d'un paramètre respectif parmi les deux parmètres, en indiquant ainsi que l'impédance de radiofréquence $Z_t$ se trouve ou non en substance sur un tel lieu selon qu'il existe ou non respectivement une différence substantielle entre les valeurs du paramètre respectif dans les deux états,

caractérisé en ce que les valeurs $Z_1$, $Z_2$ de l'impédance présentée par le système au niveau du dit accès (P) respectivement dans les deux états, $Z_1$ différant de $Z_2$, et les valeurs $A_1$, $A_2$ du gain produit entre cet accès (P) et le dispositif indicateur (Rx) par les réseaux auxiliaires ($N_1$, $N_2$) respectivement dans les deux états, $A_1$ différant de $A_2$, ont été choisies pour définir soit le lieu souhaité, soit deux lieux souhaités dans le plan d'impédance complexe d'une manière telle que l'absence de toute différence entre les valeurs respectives dans les deux états de l'amplitude indique que la valeur $Z_t$ de l'impédance de radiofréquence satisfait à l'équation

$$| A_1 Z_1/(Z_t+Z_1) | = | A_2 Z_2/(Z_t+Z_2) |$$

et/ou d'une manière telle que l'absence de toute différence entre les valeurs respectives dans les deux états de la phase indique que la valeur $Z_t$ de l'impédance de radiofréquence satisfait à l'équation

$$\arg (Z_t+Z_1)=(Z_t+Z_2)+\arg A$$

où

$$A=A_1 Z_1/A_2 Z_2.$$

8. Appareil suivant la revendication 7, comprenant un dispositif (B, D) pour commuter le système alternativement dans un état et dans l'autre.

9. Appareil suivant la revendication 8, dans lequel le dispositif indicateur (Rx) comprend un dispositif pour déduire un signal démodulé du signal qui lui est fourni et pour détecter le signal démodulé de manière synchrone avec la commutation dans un état et dans l'autre.

10. Appareil suivant l'une quelconque des revendications 7 à 9, dans lequel les réseaux auxiliaires (N₁, N₂) comprennent un dispositif hybride (HT) comportant quatre accès (1, 2, 3, 4) dans lequel, dans chaque état, un premier accès (1) du dispositif HT) est couplé à l'accès (P) du réseau électrique (T, E), un deuxième accès (2) est couplé au dispositif indicateur (Rx) et un troisième accès (3) est terminé par une impédance sélectionnée (M), dans lequel le quatrième accès (4) est terminé par des impédances respectives différentes dans les deux états et dans lequel, lorsque l'impédance de radiofréquence $Z_t$ et l'impédance sélec-

tionnée (M) satisfont à une condition prédéterminée, le deuxième et le quatrième accès (2, 4) sont isolés l'un de l'autre.

11. Appareil suivant la revendication 10, dans lequel l'impédance sélectionnée (M) terminant le troisième accès (3) présente des valeurs respectives différentes dans les deux états.

12. Appareil suivant la revendication 10 ou 11, dans lequel les impédances respectives différentes qui terminent le quatrième accès (4) sont respectivement un circuit ouvert et un court-circuit.

Fig. 1

Fig. 2

Fig. 3

Fig. 4